# EUROPÄISCHE PATENTSCHRIFT

(11) **EP 4 165 743 B1**
(45) Veröffentlichungstag und Bekanntmachung des Hinweises auf die Patenterteilung: **29.04.2026**
(21) Anmeldenummer: 21731450.9
(22) Anmeldetag: 07.06.2021
(51) Int. Cl.: H02H 3/33, H02H 7/20

(54) **VORRICHTUNG UND VERFAHREN ZUR DETEKTION EINES FEHLERSTROMS IN EINER PHOTOVOLTAIK-ANLAGE, SOWIE PHOTOVOLTAIK-WECHSELRICHTER MIT DER VORRICHTUNG**
DEVICE AND METHOD FOR DETECTING A FAULT CURRENT IN A PHOTOVOLTAIC INSTALLATION, AND PHOTOVOLTAIC INVERTER COMPRISING THE DEVICE
DISPOSITIF ET PROCÉDÉ DE DÉTECTION D'UN COURANT DE DÉFAUT DANS UNE INSTALLATION PHOTOVOLTAÏQUE ET ONDULEUR PHOTOVOLTAÏQUE COMPRENANT LE DISPOSITIF

(30) Priorität: 15.06.2020 DE 102020115757; 09.09.2020 DE 102020123493
(43) Veröffentlichungstag der Anmeldung: 19.04.2023
(73) Patentinhaber: SMA Solar Technology AG, 34266 Niestetal (DE)
(72) Erfinder: SABBAN, Martin, 34123 Kassel (DE)
(86) Internationale Anmeldenummer: PCT/EP2021/065162
(87) Internationale Veröffentlichungsnummer: WO 2021/254806

(56) Entgegenhaltungen:
- EP-A1- 2 947 468
- DE-A1- 2 613 972
- US-A1- 2011 199 707

## Beschreibung

### Technisches Gebiet der Erfindung

Die Erfindung betrifft eine Vorrichtung und ein Verfahren zur Detektion eines Fehlerstroms in einer Photovoltaik-Anlage (PV-Anlage). Bei dem Fehlerstrom kann es sich insbesondere um einen relativ kleinen resistiven Strom handeln, der zusätzlich zu einem im Normalbetrieb der PV-Anlage stets vorhandenen und relativ großen kapazitiven Ableitstrom auftreten kann. Die Erfindung betrifft zusätzlich einen Photovoltaik-Wechselrichter (PV-Wechselrichter) mit einer derartigen Vorrichtung.

### Stand der Technik

Eine Photovoltaik-Anlage (PV-Anlage) kann eine Vielzahl an elektrischen Komponenten, insbesondere an Photovoltaik (PV) - Modulen umfassen, die in dezentraler Weise über eine große Fläche verteilt sind. Eine Gruppe von PV-Modulen, die stringweise, also untereinander in Form einer Reihenschaltung gruppiert ist, wird auch Photovoltaik-String (PV-String) genannt. Ein Photovoltaik-(PV-)Generator einer Photovoltaik-(PV-)Anlage kann einen oder mehrere Photovoltaik-(PV-)Teilgeneratoren aufweisen, die parallel zueinander gegebenenfalls jeweils über einen separaten DC/DC-Wandler mit einem gemeinsamen Gleichspannungs-Zwischenkreis (DC-Zwischenkreis) eines PV-Wechselrichters verbunden sind. Jeder der PV-Teilgeneratoren kann einen oder mehrere parallel zueinander verschaltete PV-Strings aufweisen. Konstruktionsbedingt weisen die PV-Module einer PV-Anlage stets eine elektrische Kapazität gegenüber ihrer Umgebung, insbesondere gegenüber ihrer meist geerdeten Aufständerung auf. Diese Kapazität ist zur Funktion der PV-Anlage nicht zwingend erforderlich, ergibt sich jedoch unweigerlich aus dem mechanischen Aufbau der PV-Module. Sie wird daher oftmals als "parasitäre Kapazität" oder "Ableitkapazität" bezeichnet. Die parasitäre Kapazität der PV-Anlage steigt üblicherweise mit der Größe des ihr zugeordneten PV-Generators, weswegen ein leistungsstarker PV-Generator auch eine entsprechend große parasitäre Kapazität aufweist. Zudem ist die parasitäre Kapazität abhängig von Umgebungsbedingungen und steigt beispielsweise bei Regen aufgrund einer damit verbundenen feuchten Oberfläche der PV-Module und/oder einer wegen einer erhöhten Luftfeuchtigkeit geänderten Dielektrizitätskonstante der Luft weiter an.

In einem Normalbetrieb der PV-Anlage weisen die PV-Module des PV-Generators üblicherweise zusätzlich zu einer zwischen ihren Anschlüssen herrschenden Gleichspannung (DC-Spannung) auch eine Wechselspannung (AC-Spannung) gegenüber dem Erdpotential (PE) auf. Die AC-Spannung der PV-Module ist insbesondere, aber nicht ausschließlich bei PV-Anlagen mit einem transformatorlosen PV-Wechselrichter stark ausgeprägt. Die AC-Spannung der PV-Module gegenüber dem Erdpotential hängt von der individuellen Schaltungstopologie des PV-Wechselrichters ab und weist üblicherweise eine Frequenz auf, die einer Frequenz des AC-Netzes oder einem ganzzahligen Vielfachen der Frequenz des AC-Netzes entspricht, an das der PV-Wechselrichter ausgangsseitig angeschlossen ist. Aufgrund der AC-Spannung der PV-Module und deren parasitärer Kapazität gegenüber dem Erdpotential ergibt sich auch im normalen Betrieb der PV-Anlage stets ein mehr oder weniger starker Ableitstrom des PV-Generators gegen das Erdpotential.

Kommt es nun aufgrund eines Fehlers, z. B. einer schadhaften Leitungsisolierung, zu einem Kontakt einer geerdeten Person mit einer spannungsführenden Komponente des PV-Generators, beispielsweise der schadhaften Leitung, so ergibt sich - aufgrund des direkten Kontaktes üblicherweise sprungartig - ein zusätzlicher Fehlerstrom gegen das Erdpotential. Da ein Fehlerstrom ab einem Wert von ca. 30 mA personengefährdend sein kann, ist es normativ gefordert, einen derartigen Fehlerstrom sicher zu erkennen und bei Detektion eines derartigen Fehlerstroms weitere Maßnahmen, beispielsweise ein Abschalten und/oder Kurzschließen des PV-Generators, insbesondere des betreffenden PV-Teilgenerators einzuleiten.

Aufgrund immer größer werdender Nominalleistungen von PV-Anlagen steigen auch die parasitären Kapazitäten der zugeordneten PV-Generatoren oder PV-Teilgeneratoren und somit auch die im Normalbetrieb der PV-Anlage stets vorhandenen kapazitiven Ableitströme. Der dem Fehlerstrom zugeordnete Schwellwert von beispielsweise 30 mA bleibt jedoch konstant, kann allenfalls aufgrund strengerer normativer Beschränkungen noch verkleinert werden. Daher kann ein eventuell vorhandener Fehlerstrom bedeutend kleiner im Vergleich zu dem stets vorhandenen kapazitiven Ableitstrom der PV-Anlage sein. Die Detektion des Fehlerstroms wird daher aufgrund des geringen Signal/Rausch-Verhältnisses und den damit verbundenen empfindlich auszulegenden Messsystemen zunehmend aufwendiger und teurer. Es ist daher wünschenswert, insbesondere auch bei größeren PV-Anlagen einen potentiell auftretenden Fehlerstrom sicher und dennoch kostengünstig detektieren zu können, insbesondere dann, wenn der potentiell auftretende Fehlerstrom klein gegen den im normalen Betrieb der PV-Anlage stets vorhandenen kapazitiven Ableitstrom ist.

Aus der Druckschrift EP 2372857 A1 ist ein Verfahren zur Bestimmung eines Fehlerstromanteils eines Differenzstroms bekannt, wobei der Differenzstrom aus einem Ableitstromanteil und einem Fehlerstromanteil zusammengesetzt ist. Bei dem Verfahren wird der Differenzstrom als Stromsumme über den Strom eines Wechselstromgenerators führende AC-Leitungen erfasst. Ein von Spannungen an dem Wechselstromgenerator gegenüber dem Erdpotential abhängiges elektrisches Signal wird hinsichtlich einer Kapazität gegenüber dem Erdpotential mit einem Skalierungsfaktor multipliziert. Schließlich wird das derart skalierte elektrische Signal als Maß für den Ableitstromanteil von dem Differenzstrom subtrahiert.

Aus der Druckschrift US 2011/199707 A1 ist eine Anordnung zur Detektion eines Fehlerstroms in einer PV-Anlage mit mindestens einem ersten PV-String und einem zweiten PV-String bekannt, wobei die Anordnung einen Durchsteckwandler zum Messen des Fehlerstroms in den beiden PV-Strings umfasst und wobei die DC-Leitungen des ersten und des zweiten PV-Strings gemeinsam von dem Durchsteckwandler umgeben werden.

### Aufgabe der Erfindung

Der Erfindung liegt die Aufgabe zugrunde, eine Vorrichtung und ein Verfahren anzugeben, mit der/dem auch kleine Fehlerströme innerhalb üblicherweise hoher Ableitströme einer PV-Anlage sicher erkannt werden können. Dabei soll die Vorrichtung / das Verfahren einfach und kostengünstig realisierbar sein. Es ist zudem Aufgabe der Erfindung, einen zur Durchführung des Verfahrens geeigneten PV-Wechselrichter aufzuzeigen.

### Lösung

Die Aufgabe, eine Vorrichtung zur Detektion eines Fehlerstroms in einer PV-Anlage anzugeben, wird erfindungsgemäß durch eine Vorrichtung mit den Merkmalen des unabhängigen Patentanspruchs 1 gelöst. Die Aufgabe, ein Verfahren zur Detektion eines Fehlerstroms in einer PV-Anlage anzugeben, wird erfindungsgemäß durch ein Verfahren mit den Merkmalen des unabhängigen Anspruchs 5 gelöst. Die Aufgabe, eine erfindungsgemäßen PV-Wechselrichter aufzuzeigen, wird erfindungsgemäß mit den Merkmalen des nebengeordneten Anspruchs 13 gelöst. Vorteilhafte Ausführungsformen der Detektionsvorrichtung sind in den abhängigen Ansprüchen 2 bis 4, vorteilhafte Ausführungsformen des Verfahrens in den abhängigen Ansprüchen 6 bis 12 wiedergegeben. Vorteilhafte Ausführungsformen des PV-Wechselrichters sind in den abhängigen Ansprüchen 14 und 15 aufgeführt.

### Beschreibung der Erfindung

Eine Detektionsvorrichtung zur Detektion eines Fehlerstroms an einem PV-Generator und/oder an dem PV-Generator zugeordneten DC-Leitungen einer PV-Anlage weist zumindest einen Stromwandler und eine mit dem zumindest einen Stromwandler verbundene Auswerteeinheit auf. Der PV-Generator weist zumindest einen ersten PV-String und einen zweiten PV-String auf, die über jeweils zwei DC-Leitungen mit einem PV-Wechselrichter der PV-Anlage verbunden sind. Der Stromwandler ist als ein von dem ersten PV-String und dem zweiten PV-String gemeinsam nutzbarer oder gemeinsam genutzter Stromwandler ausgebildet. Ein Stromwandler ist ein Messgerät, das einen Strom in ein weiterverarbeitbares Messsignal umwandelt. Ein Messsignal des Stromwandlers repräsentiert dabei eine Differenz eines von dem ersten PV-String gegen das Erdpotential fließenden ersten Summenstroms und eines von dem zweiten PV-String gegen das Erdpotential fließenden zweiten Summenstroms. Ein Fehlerstrom ist, sofern er auftritt, insbesondere Bestandteil des ersten und/oder des zweiten Summenstroms. Daher kann der Fehlerstrom auch über die Differenz des ersten Summenstroms und des zweiten Summenstroms detektiert werden.

Eine solche Detektionsvorrichtung hat den Vorteil, dass ein in der Regel im Normalbetrieb der PV-Anlage stets vorhandener gegen Erdpotential (PE) fließender Ableitstrom zweier PV-Strings weitgehend kompensiert, unter Umständen auch ausgelöscht werden kann. Der erste Summenstrom umfasst dabei insbesondere die Summe aus einem ersten gegen Erdpotential fließenden Ableitstrom des ersten PV-Strings und - falls er auftritt - eines ebenfalls gegen das Erdpotential fließenden Fehlerstroms am ersten PV-String. Der zweite Summenstrom umfasst dabei insbesondere die Summe aus einem zweiten gegen das Erdpotential fließenden Ableitstrom des zweiten PV-Strings und - falls er auftritt - eines ebenfalls gegen das Erdpotential fließenden Fehlerstroms am zweiten PV-String. Vorzugsweise sind der erste PV-String und der zweite PV-String sowohl hinsichtlich der Anzahl der PV-Module als auch deren Typ gleich, zumindest jedoch ähnlich aufgebaut. Zusätzlich handelt es sich bevorzugterweise um benachbarte, d. h. räumlich nahe beieinander angeordnete, PV-Strings. Auf diese Weise herrschen ähnliche Umgebungsbedingungen an dem ersten und dem zweiten PV-String. Daher sind die beiden PV-Strings hinsichtlich ihrer parasitären Kapazitäten ähnlich ausgelegt, so kann der erste Ableitstrom durch die Bildung der Differenz mit dem zweiten Ableitstrom größtenteils ausgelöscht, zumindest jedoch signifikant reduziert werden.

Gleiches gilt auch im umgekehrten Fall, nämlich, dass auch der zweite Ableitstrom durch die Bildung der Differenz mit dem ersten Ableitstrom weitestgehend kompensiert und unter Umständen sogar ausgelöscht werden kann. Auf diese Weise wird ein im normalen Betrieb der PV-Anlage üblicherweise vorhandenes den eventuell auftretenden Fehlerstrom überlagerndes Hintergrundsignal der Ableitströme weitestgehend reduziert. Tritt nun in einem der Summenströme zusätzlich zu dem stets vorhandenen Ableitstrom ein Fehlerstrom auf, so hebt sich der Fehlerstrom aus dem stets vorhandenen Hintergrundsignal umso stärker hervor, je kompensierender die Differenz der Ableitströme von erstem und zweitem PV-String ausfällt. In jedem Fall ist ein den Fehlerstrom repräsentierendes Messsignal signifikanter, als dies ohne die Differenzbildung der Summenströme der Fall wäre. Da das Hintergrundsignal des Stromwandlers deutlich reduziert ist, kann der Stromwandler auf einen kleinen Nominalstrom ausgelegt sein, der auch kleine Fehlerströme detektiert. Das üblicherweise hohe Hintergrundsignal oder Rauschsignal, d. h. der gesamte und in der Regel wesentlich größere Ableitstrom eines PV-Strings, wird aufgrund der Differenzbildung beider Summenströme nicht, zumindest jedoch nur in deutlich reduziertem Maße mitgemessen. Zusätzlich können auch sich gleich ändernde Umweltbedingungen, die üblicherweise ähnlich auf die parasitären Kapazitäten der benachbarten PV-Strings wirken, zumindest teilweise kompensiert werden.

Vorteilhafte Ausgestaltungen der Erfindung sind in der nachfolgenden Beschreibung und den Unteransprüchen angegeben, deren Merkmale einzeln und in beliebiger Kombination miteinander angewendet werden können.

Gemäß der Erfindung ist der gemeinsam nutzbare Stromwandler als ein gemeinsam nutzbarer Durchsteckwandler ausgebildet. Unter einem Durchsteckwandler im Sinne der Anmeldung ist ein induktiv operierender Stromwandler gemeint. Ein Durchsteckwandler kann zumindest eine Spule aufweisen, die zur Detektion eines durch einen Leiter fließenden Stroms von einem Magnetfeld des stromdurchflossenen Leiters durchsetzt wird. Dabei kann die Spule den stromdurchflossenen Leiter an einer Stelle entlang seines Umfangs zumindest teilweise umgeben. Der Durchsteckwandler kann zur Bündelung des Magnetfeldes des zu vermessenden Leiters einen üblicherweise ringförmigen Magnetkern aufweisen, um den die Spule gewickelt ist, sodass der Magnetkern die Spule durchsetzt. In diesem Fall wird der Leiter entlang seines Umfanges zumindest teilweise auch von dem Magnetkern umgeben. Bei dem Magnetkern kann es sich um einen geschlossenen, als auch um einen nicht geschlossenen, also einen einen Spalt aufweisenden Magnetkern handeln. Der Magnetkern kann ähnlich einer Stromzange aufklappbar ausgelegt sein, um ein Umschließen des Leiters entlang seines Umfanges auf einfache Weise zu ermöglichen. Bei einem Durchsteckwandler, dessen Magnetkern einen Spalt aufweist, kann die Detektion des durch den Leiter fließenden Stroms auch über ein an dem Spalt lokalisiertes magnetisches Streufeld erfolgen, das von dem zu vermessenden Strom erzeugt wird. Hierzu kann der Durchsteckwandler alternativ zu der Spule einen Hallsensor aufweisen, über den das magnetische Streufeld erfasst wird. Der Durchsteckwandler kann zusätzlich eine Kompensationsschaltung aufweisen, über die ein von dem stromdurchflossenen Leiter in dem Magnetkern erzeugtes Magnetfeld kompensiert wird, wobei die zur Kompensation notwendigen Eingangsgrößen der Kompensationsschaltung als Maß für den zu vermessenden Strom genutzt werden. Generell kann der Durchsteckwandler zur Messung von AC-Strömen und gegebenenfalls auch von DC-Strömen ausgelegt sein. Mit dem Durchsteckwandler lässt sich auch eine Kombination von Strömen, die zu einem Zeitpunkt in mehreren Leitern fließen, detektieren. Dies ist dann der Fall, wenn die stromdurchflossenen Leiter gemeinsam von dem Durchsteckwandler umgeben werden, das heißt die stromdurchflossenen Leiter den Durchsteckwandler gemeinsam durchsetzen. Hierbei durchsetzen die Magnetfelder, die durch die in den mehreren Leitern fließenden Ströme erzeugt werden, auch gleichzeitig die zumindest eine Spule des Durchsteckwandlers. Dabei werden Ströme, deren Magnetfelder die zumindest eine Spule des Durchsteckwandlers in gleichen Richtungen durchsetzen miteinander addiert, während Ströme, die die zumindest eine Spule des Durchsteckwandlers in entgegengesetzten Richtungen durchsetzen, voneinander subtrahiert werden. Die Subtraktion der Ströme ist beispielsweise dann der Fall, wenn die in den zwei Leitern fließenden Ströme den Durchsteckwandler in entgegengesetzten Richtungen durchsetzen. Gemäß der Erfindung wird nun der Durchsteckwandler zur Detektion des Messsignals von den zwei DC-Leitungen des ersten PV-Strings und den zwei DC-Leitungen des zweiten PV-Strings durchsetzt. Dabei sind die beiden DC-Leitungen des ersten PV-Strings relativ zu den zwei DC-Leitungen des zweiten PV-Strings so orientiert, dass die darin fließenden Summenströme, die im normalen Betrieb der PV-Anlage im Wesentlichen durch den ersten gegen Erdpotential fließenden Ableitstrom und den zweiten gegen Erdpotential fließenden Ableitstrom gebildet werden, den Durchsteckwandler in entgegengesetzten Richtungen durchsetzen. Auf diese Weise bietet der Durchsteckwandler als Stromwandler eine einfache Form der Differenzbildung des ersten und des zweiten Summenstroms, wobei die Differenzbildung durch ein hinsichtlich der Stromrichtungen entgegengesetztes Durchsetzen des Durchsteckwandlers mit dem von dem ersten PV-String gegen Erdpotential fließenden ersten Ableitstrom und dem von dem zweiten PV-String gegen Erdpotential fließenden zweiten Ableitstrom realisiert wird.

Gemäß der Erfindung sind die zwei DC-Leitungen des ersten PV-Strings so zueinander angeordnet, dass während eines Normalbetriebs der PV-Anlage ein darin fließender DC-Strom zwischen dem ersten PV-String und dem PV-Wechselrichter den Durchsteckwandler in zwei zueinander entgegengesetzten Richtungen durchsetzt. Auch die zwei DC-Leitungen des zweiten PV-Strings sind so zueinander angeordnet, dass während eines Normalbetriebs der PV-Anlage ein in den DC-Leitungen zwischen dem zweiten PV-String und dem PV-Wechselrichter fließender DC-Strom den Durchsteckwandler in zwei zueinander entgegengesetzten Richtungen durchsetzt. Dabei ist eine mit einem positiven Pol des ersten PV-Strings verbundene DC-Leitung relativ zu einer mit einem positiven Pol des zweiten PV-Strings verbundenen DC-Leitung so angeordnet, dass während eines Normalbetriebs der PV-Anlage die zwischen den jeweiligen PV-Strings und dem PV-Wechselrichter fließenden DC-Ströme in den den positiven Polen zugeordneten DC-Leitungen den Durchsteckwandler in entgegengesetzten Richtungen durchsetzen. Auf diese Weise wird in dem Messsignal des Durchsteckwandlers sowohl ein in der positiven DC-Leitung fließender DC-Strom des ersten PV-Strings durch den in der negativen DC-Leitung fließenden DC-Strom des ersten PV-Strings kompensiert. Zusätzlich wird in dem Messsignal des Durchsteckwandlers auch ein in der positiven DC-Leitung fließender DC-Strom des zweiten PV-Strings durch den in der negativen DC-Leitung fließenden DC-Strom des zweiten PV-Strings kompensiert. Dabei stellen die zwischen den PV-Strings und dem PV-Wechselrichter fließenden DC-Ströme jeweils einen Arbeitsstrom des ersten PV-Strings beziehungsweise des zweiten PV-Strings dar. Auch diese DC-Ströme sind im Normalbetrieb der PV-Anlage stets vorhanden. Zusätzlich zu den DC-Strömen wird jedoch auch der erste gegen Erdpotential fließende Ableitstrom des ersten PV-Strings durch den zweiten gegen Erdpotential fließenden Ableitstrom des zweiten PV-Strings kompensiert und umgekehrt. Dies ist der Fall, da der erste gegen Erdpotential fließende Ableitstrom des ersten PV-Strings den Durchsteckwandler in der entgegengesetzten Richtung wie der zweite gegen Erdpotential fließende Ableitstrom des zweiten PV-Strings durchsetzt.

Gemäß einer weiteren Ausführungsform der Detektionsvorrichtung kann der erste PV-String eine Kombination aus zwei PV-Teilstrings umfassen. Dabei sind die DC-Leitungen der PV-Teilstrings so zueinander angeordnet, dass während eines Normalbetriebs der PV-Anlage die DC-Ströme in den den positiven Polen der PV-Teilstrings zugeordneten DC-Leitungen den Durchsteckwandler in gleichen Richtungen durchsetzen. Ebenso sind die den negativen Polen der PV-Teilstrings zugeordneten DC-Leitungen so zueinander angeordnet, dass während eines Normalbetriebs der PV-Anlage die in den den negativen Polen zugeordneten DC-Leitungen fließenden DC-Ströme den Durchsteckwandler in gleichen Richtungen durchsetzen. Hingegen ist jede dem positiven Pol der PV-Teilstrings zugeordnete DC-Leitung relativ zu jeder dem negativen Pol der PV-Teilstrings zugeordneten DC-Leitung so angeordnet, dass während eines Normalbetriebs der PV-Anlage die DC-Ströme in den jeweiligen DC-Leitungen den Durchsteckwandler in entgegengesetzten Richtungen durchsetzen. Dabei können die PV-Teilstrings hinsichtlich ihrer Nominalleistung vorteilhafterweise so ausgelegt sein, dass eine Nominalleistung des ersten PV-Teilstrings um zumindest 50% kleiner ist, bevorzugt um zumindest 70% kleiner ist als eine Nominalleistung des zweiten PV-Teilstrings. Durch eine Behandlung von zwei PV-Strings als PV-Teilstrings und deren Zusammenfassung in lediglich einen PV-String kann auch dann noch eine hinreichende Kompensation der gegen Erdpotential fließenden Ableitströme - und damit verbunden ein noch ausreichend hohes Signal/Rausch-Verhältnis bei der Detektion des Fehlerstroms - erzielt werden, wenn der gemeinsam genutzte Durchsteckwandler insgesamt eine ungerade Anzahl an ihn durchsetzenden PV-Strings aufweist.

In einer Ausführungsform der Detektionsvorrichtung ist der Stromwandler auf einen Maximalwert ausgelegt, der einem Wert von maximal 50%, bevorzugt von maximal 25%, besonders bevorzugt von maximal 15% des größeren der beiden Werte aus dem ersten Ableitstrom und dem zweiten Ableitstrom entspricht. Dabei kennzeichnet der erste Ableitstrom einen im Normalbetrieb der PV-Anlage von dem ersten PV-String gegen das Erdpotential fließenden Strom und der zweite Ableitstrom einen im Normalbetrieb der PV-Anlage von dem zweiten PV-String gegen das Erdpotential fließenden Strom. In diesem Zusammenhang bezeichnet der Normalbetrieb der PV-Anlage einen Betriebszustand, bei dem die PV-Anlage in Betrieb ist und kein oder nahezu kein Fehlerstrom fließt. Diese Ausführungsform ermöglicht eine besonders kostengünstige Ausführung des Stromwandlers.

In einer Ausführungsform ist die Detektionsvorrichtung ausgelegt und eingerichtet, nicht nur einen Fehlerstrom I_{Fehl} an einem oder mehreren PV-Strings zu detektieren, sondern auch denjenigen PV-String der PV-Anlage zu ermitteln, bei dem der Fehlerstrom I_{Fehl} auftritt. Hierzu weist die PV-Anlage, an der die Detektion des Fehlerstroms I_{Fehl} mittels der Detektionsvorrichtung erfolgen soll, eine Anzahl n, mit n>2, PV-Strings auf. Zusätzlich weist die Detektionsvorrichtung eine gleichgroße Anzahl n, mit n>2, an Durchsteckwandlern auf, die mit der Auswerteinheit der Detektionsvorrichtung verbunden sind. Zur Detektion des Messsignals wird jeder der Durchsteckwandler von den DC-Leitungen zweier verschiedener PV-Strings durchsetzt. Zusätzlich ist die Durchsetzung der Durchsteckwandler so ausgebildet, dass die DC-Leitungen jedes PV-Strings jeweils zwei verschiedene Durchsteckwandler durchsetzen. Die Kombination der den jeweiligen PV-String durchsetzenden Durchsteckwandler charakterisiert dann den PV-String.

Diese Ausführungsform bietet den Vorteil, dass nicht nur ein Fehlerstrom in der PV-Anlage erkannt werden kann, sondern auch der dem Fehlerstrom zugeordnete PV-String ermittelt werden kann. Konkret durchsetzt nämlich jeder PV-String eine bestimmte für den jeweiligen PV-String individuelle Kombination aus zwei verschiedenen Durchsteckwandlern mit jeder seiner DC-Leitungen. Ein Fehlerstrom eines bestimmten PV-Strings führt daher zu einem entsprechendem Messsignal genau derjenigen Durchsteckwandler, die von dem entsprechenden PV-String durchsetzt werden. Demzufolge ist derjenige PV-String, dessen DC-Leitungen beide Durchsteckwandler durchsetzen, die einen Fehlerstrom detektieren, somit sehr wahrscheinlich auch derjenige PV-String, der dem Fehlerstrom zugeordnet werden kann.

Ein erfindungsgemäßes Verfahren dient zur Detektion eines Fehlerstroms in einer PV-Anlage mit einer erfindungsgemäßen Detektionsvorrichtung. Dabei weist ein PV-Generator der PV-Anlage zumindest einen ersten PV-String und einen zweiten PV-String auf, die über jeweils zwei DC-Leitungen mit einem PV-Wechselrichter der PV-Anlage verbunden sind. Das Verfahren weist zumindest die folgenden Schritte auf:
- Detektion eines Messsignals des zumindest einen Stromwandlers der Detektionsvorrichtung, wobei das Messsignal eine Differenz eines von dem ersten PV-String gegen das Erdpotential fließenden ersten Summenstroms und eines von dem zweiten PV-String gegen das Erdpotential fließenden zweiten Summenstroms repräsentiert;
- Signalisierung eines Fehlerstroms, wenn das detektierte Messsignal einen ersten Schwellwert übersteigt.

Bei dem Verfahren ergeben sich die bereits in Verbindung mit der Detektionsvorrichtung erläuterten Vorteile.

In einer Ausführungsform des Verfahrens erfolgt die Signalisierung des Fehlerstrom nur dann, wenn das Messsignal den ersten Schwellwert mit einem sprungartigen Anstieg überschreitet. Dabei kann der sprungartige Anstieg des Messsignals eine Änderung der Differenz des ersten Summenstroms und des zweiten Summenstroms von zumindest 10mA, vorteilhafterweise von zumindest 20mA repräsentieren. Eine solche Ausführungsform bietet die Möglichkeit, einen von einer Person verursachten Fehlerstrom gezielter zu erkennen und von anderen Effekten, die langsam, gegebenenfalls schleichend erfolgende Änderungen der Summenströme bewirken, zu unterscheiden. Dabei wird der Effekt ausgenutzt, dass eine Änderung eines Summenstroms in der Regel sprunghaft erfolgt, wenn eine Person in Kontakt zu einer spannungsführenden Komponente kommt. Demzufolge ändert sich auch das Messsignal sprunghaft. Langsame Änderungen in der Differenz beider Summenströme, beispielsweise aufgrund von ungleichen Umgebungsbedingungen der PV Strings und damit verbundenen langsam erfolgenden Änderungen in den Ableitströmen der beiden PV-Strings werden so ausgeblendet und nicht signalisiert. Als langsame Änderung ist insbesondere eine sich über viele Sekunden bis Minuten gegebenenfalls auch Stunden erstreckende Änderung zu verstehen, wie sie beispielsweise wetterbedingt erfolgen kann.

In einer Ausführungsform des Verfahrens kann ein resistiver Stromanteil des von dem zumindest einen Stromwandler detektierten Messsignals bestimmt werden. Optional kann dabei der Fehlerstrom nur dann signalisiert werden, wenn das von dem Stromwandler erzeugte Messsignal bei Überschreitung des ersten Schwellwertes eine sprunghafte Änderung eines resistiven Stromanteils um zumindest 10mA, vorteilhafterweise um zumindest 20 mA aufweist. Diese Bestimmung des resistiven Stromanteils ermöglicht ebenfalls eine gezieltere Erkennung eines von einer Person verursachten Fehlerstroms. Im Gegensatz zum Ableitstrom, der über eine parasitäre Kapazität erfolgt und damit einen Blindstrom darstellt, ist der aufgrund eines Personenkontaktes fließende Fehlerstrom üblicherweise ein resistiver Strom. In einer Weiterbildung des Verfahrens lässt sich z. B. ein Verhältnis des resistiven und damit ohmschen Anteils zum kapazitiven Anteil über eine Phasenbeziehung zwischen dem gegen Erdpotential fließenden Strom und der diesen Strom verursachenden AC-Spannung der PV-Module ermitteln.

In einer Ausführungsform des Verfahrens weist der PV-Generator der PV-Anlage eine Anzahl n, mit n>2, an PV-Strings auf. Zusätzlich weist die Detektionsvorrichtung eine gleichgroße Anzahl n, mit n>2, an Durchsteckwandlern auf. Dabei wird jeder der Durchsteckwandler von den DC-Leitungen zweier verschiedener PV-Strings durchsetzt. Zusätzlich durchsetzen die DC-Leitungen jedes PV-Strings jeweils zwei verschiedene der Durchsteckwandler. Diese Ausführungsform bietet den Vorteil, dass mittels des Verfahrens nicht nur ein Fehlerstrom in der PV-Anlage erkannt werden kann, sondern auch der dem Fehlerstrom zugeordnete PV-String der PV-Anlage ermittelt werden kann. Jeder der PV-Strings, also auch der dem Fehlerstrom zugeordnete PV-String, durchsetzt nämlich zwei verschiedene Durchsteckwandler mit jeder seiner zwei DC-Leitungen. Ein Fehlerstrom in einem bestimmten der PV-Strings führt daher zu einem entsprechenden Messsignal in genau den Stromwandlern, die von dem bestimmten PV-String durchsetzt werden. Derjenige PV-String, dessen DC-Leitungen beide Durchsteckwandler durchsetzen, die einen Fehlerstrom detektieren, ist somit sehr wahrscheinlich derjenige PV-String, der dem Fehlerstrom zugeordnet werden kann.

In einer Ausführungsform der Erfindung kann in Reaktion auf die Signalisierung des Fehlerstroms der gesamte PV-Generator freigeschaltet werden. Alternativ dazu ist es jedoch auch möglich, dass in Reaktion auf die Signalisierung des Fehlerstroms lediglich der den Fehlerstrom verursachende PV-String des PV-Generators freigeschaltet wird, während die restlichen nicht von dem Fehler betroffenen PV-Strings oder PV-Teilgeneratoren weiterbetrieben werden. Auf diese Weise kann ein Ausfall einer mit der Freischaltung verbundenen Einspeisevergütung minimiert werden. Durch das Freischalten des den Fehlerstrom verursachenden PV-Generators oder des den Fehlerstrom verursachenden PV-Strings wird der Fehlerstrom des PV-Generators beziehungsweise des entsprechenden PV-Strings unterdrückt. Dabei kann das Freischalten z. B. dadurch erfolgen, dass der betreffende PV-String vom PV-Wechselrichter getrennt, gegebenenfalls auch kurzgeschlossen wird. Dabei sollte ein Kurzschluss des PV-Strings ohne Trennung des PV-Wechselrichters vom AC-Netz möglichst nur dann erfolgen, wenn der betreffende PV-String eine Rückstromdiode aufweist oder über einen DC/DC-Wandler mit dem DC-Zwischenkreis des PV-Wechselrichters verbunden ist.

Bei einer Ausführungsform des Verfahrens können DC-Leitungen einer ersten Gruppe an PV-Strings 2.1-2.k und einer gleich großen zweiten Gruppe an PV-Strings 2.k+1 - 2.n einen gemeinsamen Durchsteckwandler so durchsetzen, dass jeder der PV-Strings 2.1-2.k der ersten Gruppe einen gegen das Erdpotential fließenden ersten Summenstrom aufweist, der von einem gegen das Erdpotential fließenden zweiten Summenstrom eines korrespondierenden PV-Strings der zweiten Gruppe 2.k+1 - 2.n zumindest annähernd kompensiert wird. In dieser Ausführungsform kann ein Durchsteckwandler gleichzeitig für 4, 6, 8 oder mehr geradzahlige PV-Strings verwendet werden. Indem zwei PV-Strings optional mit unterschiedlichen Nominalleistungen als PV-Teilstrings behandelt und in einem PV-String zusammengefasst werden können, ist es auch möglich, dass ein gemeinsam genutzter Durchsteckwandler insgesamt eine ungerade Anzahl von ihm zugeordneten PV-Strings aufweist. Insgesamt kann hierdurch eine kostengünstige Lösung der Detektionsvorrichtung wie auch des Verfahrens ermöglicht werden.

Bei einem vorteilhaften Verfahren ähneln sich die zwei PV-Strings eines gemeinsam genutzten Stromwandlers so, dass bei einem Normalbetrieb der PV-Anlage eine Differenz des von dem ersten PV-String gegen das Erdpotential fließenden ersten Ableitstroms und des von dem zweiten PV-String gegen das Erdpotential fließenden zweiten Ableitstroms einen zweiten Schwellwert unterschreitet. Gemeinsam benutzt bedeutet, dass das von dem Stromwandler detektierte Messsignal von der Differenz von mit diesen PV-Strings zusammenhängenden Strömen abhängt. Dabei sollten die zusammengefassten PV-Strings vorteilhafterweise hinsichtlich ihrer parasitären Kapazitäten möglichst so ähnlich gewählt werden, dass der zweite Schwellwert hierbei einem Wert von 25% bezogen auf ein Maximum aus dem ersten Ableitstrom und dem zweiten Ableitstrom entspricht.

Ein erfindungsgemäßer Photovoltaik(PV)-Wechselrichter mit einem AC-Ausgang zum Anschluss an ein Wechselspannungsnetz (AC-Netz) und zumindest zwei DC-Eingängen zum Anschluss von zumindest zwei PV-Strings eines PV-Generators, weist bevorzugt eine zuvor beschriebene Detektionsvorrichtung auf und/oder ist zur Durchführung des zuvor beschriebenen Verfahrens ausgelegt und eingerichtet. Der PV-Wechselrichter kann als einphasiger PV-Wechselrichter oder mehrphasiger, insbesondere dreiphasiger PV-Wechselrichter ausgebildet sein. Der PV-Wechselrichter kann einstufig ausgebildet und insbesondere frei von einem zwischen einem der DC-Eingänge und einem DC/AC-Wandler des PV-Wechselrichters angeordneten DC/DC-Wandler sein. Alternativ dazu ist es jedoch auch möglich, dass der PV-Wechselrichter mehrstufig ausgebildet ist und einen einem DC/AC-Wandler des PV-Wechselrichters vorgeschalteten DC/DC-Wandler aufweist. In einer weiteren Ausführungsform kann der PV-Wechselrichter als sogenannter Multi-String PV-Wechselrichter ausgebildet sein, bei der jeder der beiden PV-Strings jeweils über einen separaten DC/DC-Wandler mit einem gemeinsamen DC-Zwischenkreis verbunden ist.

Gemäß einer vorteilhaften Ausführungsform weist der PV-Wechselrichter eine nominelle Leistung von zumindest 10 kW auf. Bei einer solchen Auslegung, insbesondere für große PV Anlagen mit dem entsprechend ausgelegten PV-Wechselrichter kommen die Vorzüge des Verfahrens und der Detektionsvorrichtung besonders zum Tragen.

In einer weiteren Ausführungsform ist der PV-Wechselrichter als ein transformatorloser PV-Wechselrichter ausgebildet. Bei einem solchen transformatorlosen PV-Wechselrichter können die von den PV-Strings gegen das Erdpotential fließenden Ableitströme besonders stark ausgeprägt sein. Das Verfahren und die Detektionsvorrichtung können also bei solchen PV-Wechselrichtern besonders vorteilhaft eingesetzt werden.

### Kurzbeschreibung der Figuren

Im Folgenden wird die Erfindung mithilfe von in den Figuren dargestellten Ausführungsbeispielen weiter erläutert und beschrieben. Es zeigen
- **Fig. 1**: eine PV-Anlage mit einem PV-Wechselrichter;
- **Fig. 2**: eine erfindungsgemäße Detektionsvorrichtung in einer ersten Ausführungsform mit zwei PV-Strings und einem gemeinsam genutzten Durchsteckwandler;
- **Fig. 3**: eine erfindungsgemäße Detektionsvorrichtung in einer zweiten Ausführungsform mit drei PV-Strings und drei Durchsteckwandlern;
- **Fig. 4**: ein Ablaufdiagramm des erfindungsgemäßen Verfahrens zur Detektion eines Fehlerstroms in einer Ausführungsform.

### Figurenbeschreibung

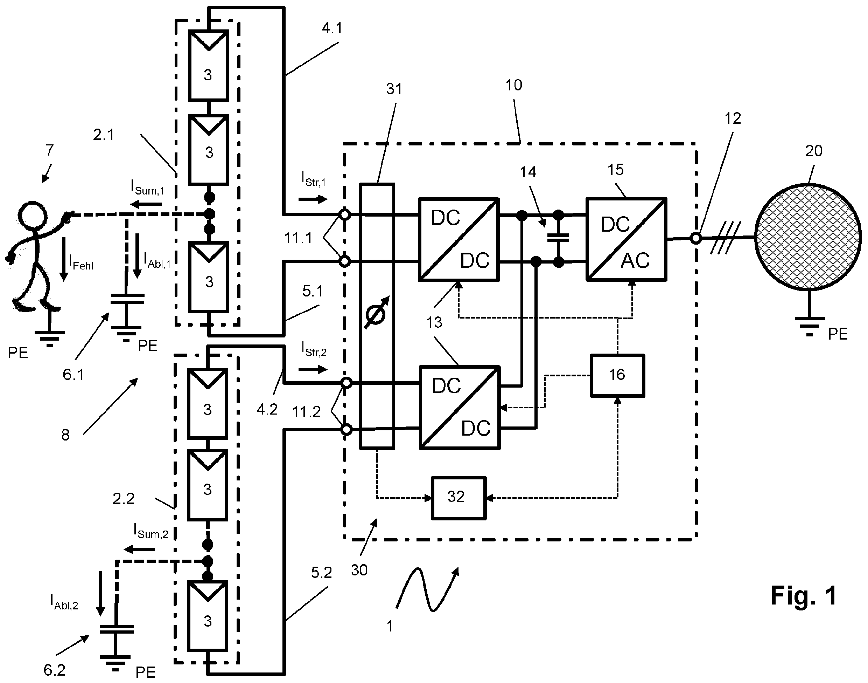

In **Fig. 1** ist eine Photovoltaik-(PV-)Anlage 1 mit einem PV-Wechselrichter 10 dargestellt.

Die PV-Anlage 1 beinhaltet einen ersten PV-String 2.1 und einem zweiten PV-String 2.2. Jeder PV-String 2.1, 2.2 weist mehrere in Reihe geschaltete PV-Module 3 auf. Beide PV-Strings 2.1, 2.2 bilden einen PV-Generator 8. Die beiden PV-Strings 2.1, 2.2 sind hinsichtlich Anzahl und Typ der PV-Module 3 ähnlich, insbesondere gleich ausgebildet. Zusätzlich sind die beiden PV-Strings 2.1, 2.2 so nah beieinander angeordnet, dass sie zumindest ähnlichen Umgebungsbedingungen hinsichtlich Einstrahlung und Temperatur unterworfen sind. Der Photovoltaik-Wechselrichter 10 ist exemplarisch als sogenannter Multi-String-Wechselrichter ausgebildet. Hierzu weist er mindestens zwei DC-Eingänge 11.1, 11.2 für DC-Leitungen 4.1, 5.1, 4.2, 5.2 der beiden PV-Strings 2.1, 2.2 aus Photovoltaikmodulen 3 auf. Jeder der DC-Eingänge 11.1, 11.2 ist über einen separaten DC/DC-Wandler 13 mit einem gemeinsamen DC-Zwischenkreis 14 verbunden. Der gemeinsame DC-Zwischenkreis 14 ist wiederum mit einer DC-Seite eines DC/AC-Wandlers 15 verbunden. Die AC-Seite des DC/AC-Wandlers 15 ist mit einem AC-Ausgang 12 des PV-Wechselrichters 10 verbunden. An den in **Fig. 1** exemplarisch dreiphasig ausgelegten AC-Ausgang 12 des PV-Wechselrichter 10 ist ein ebenfalls dreiphasig ausgelegtes Wechselspannungs-(AC-)Netz 20 angeschlossen. Die DC-Eingänge 11.1, 11.2 sind über einen Stromwandler 31 mit den DC/DC-Wandlern 13 verbunden, Eine Steuerungseinheit 16 des PV-Wechselrichters 10 steuert die Schalter der DC/DC-Wandler 13 und des DC/AC-Wandlers 15 zur gewünschten Spannungswandlung an. Der PV-Wechselrichter 10 weist ferner eine Detektionsvorrichtung 30 mit einem Stromwandler 31 und einer mit dem Stromwandler 31 verbundenen Auswerteeinheit 32 auf. Der Stromwandler 31 ist zwischen den Eingängen 11.1, 11.2 und den DC/DC-Wandlern 13 des PV-Wechselrichters 10 angeordnet und kann als Durchsteckwandler ausgebildet sein. Dabei repräsentiert ein Messsignal des Stromwandlers 31 eine Differenz eines von dem ersten PV-String 2.1 gegen das Erdpotential PE fließenden ersten Summenstroms I_{Sum,1} und eines von dem zweiten PV-String 2.2 gegen das Erdpotential PE fließenden zweiten Summenstroms I_{Sum,2}. Die Auswerteeinheit 32 ist ausgebildet, das von dem Stromwandler gemessene Messsignal weiterzuverarbeiten, z. B. auszuwerten. Sie ist zudem steuerungstechnisch und zur Kommunikation mit der Steuerungseinheit 16 des PV-Wechselrichters 10 verbunden.

Der erste PV-String 2.1 weist eine erste parasitäre Kapazität 6.1 gegenüber dem Erdpotential PE auf. Der zweite PV-String 2.2 weist eine zweite parasitäre Kapazität 6.2 gegenüber dem Erdpotential PE auf. Parasitäre Kapazitäten 6.1, 6.2 treten bei PV-Modulen 3 auf und sind von den Umgebungsbedingungen, wie z. B. Feuchtigkeit, Temperatur, Niederschlag oder ähnlichem abhängig.

Über die erste parasitäre Kapazität 6.1 fließt ein erster Ableitstrom I_{Abl,1} vom ersten PV-String 2.1 in Richtung Erdpotential PE. Über die zweite parasitäre Kapazität 6.2 fließt ein zweiter Ableitstrom I_{Abl,2} vom zweiten PV-String 2.2 in Richtung Erdpotential PE. Bei den Ableitströmen I_{Abl,1} I_{Abl,2} handelt es sich um kapazitive Blindströme, die daraus resultieren, dass einem Gleichspannungspotential der PV-Module 3 gegenüber dem Erdpotential ein AC-Potential überlagert ist. Die Ableitströme I_{Abl,1}, I_{Abl,2} sind sind zusammen mit den parasitären Kapazitäten 6.1, 6.2 von den Umgebungsbedingungen der PV-Strings 2.1, 2.2 wie Feuchtigkeit, Temperatur, Niederschlag, o. ä. abhängig. Sie können sich zeitlich gegebenenfalls stark, wenn auch zeitlich eher langsam ändern. Allerdings ändern sie sich dabei für die ähnlichen PV-Strings 2.1, 2.2 in ähnlicher Weise.

Im Fehlerfall, z. B. wenn eine geerdete Person 7 einen Kontakt zwischen einem der PV-Strings 2.1, 2.2 und dem Erdpotential PE herstellt, fließt zusätzlich zu dem Ableitstrom I_{Abl,1} I_{Abl,2} an demjenigen PV-String 2.1, 2.2, an dem der Fehlerfall verursacht wurde, ein Fehlerstrom I_{Fehl} gegen das Erdpotential PE. Dies ist in **Fig. 1** exemplarisch am Beispiel des ersten PV-Strings 2.1 illustriert.

Das Messsignal des Stromwandlers 31 repräsentiert nun die Differenz des ersten Summenstroms I_{Sum,1} und des zweiten Summenstroms I_{Sum,2}. Dabei umfasst der erste Summenstrom I_{Sum,1} die Summe aus dem ersten Ableitstrom I_{Abl,1} und - wie in **Fig. 1** dargestellt im Fehlerfall - dem Fehlerstrom I_{Fehl}. Der zweite Summenstrom I_{Sum,2} umfasst die Summe aus dem zweiten Ableitstrom I_{Abl,2} und den in einem Fehlerfall an dem zweiten PV-String 2.2 ebenfalls dort ebenfalls vorhandenen Fehlerstrom I_{Fehl}. Für den in **Fig. 1** dargestellten Fall, dass an dem zweiten Sting 2.2 kein Fehlerfall vorliegt, entspricht der zweite Summenstrom I_{Sum,2} dem zweiten Ableitstrom I_{Abl,2}.

Insbesondere bei leistungsstarken PV-Wechselrichtern 10 ohne galvanische Trennung zwischen DC- und AC-Seite entspricht der weit überwiegende Teil der Summenströme I_{Sum,1} I_{Sum,2} den Ableitströmen I_{Abl,1}, I_{Abl,2}, die durch die parasitären Kapazitäten 6.1, 6.2 verursacht werden. Für den Schutz gegen elektrischen Schlag von Personen 7 müssen nun plötzliche Änderungen der Summenströme I_{Sum,1}, I_{Sum,2} detektiert werden können, wie sie durch das Fließen lebensgefährlicher Ströme durch menschliche Körper von Personen 7 entstehen können. Derartige resistive Fehlerströme I_{Fehl} sind bereits bei Stromstärken lebensgefährlich, die deutlich unter den üblichen Stromstärken der ungefährlichen kapazitiven Ableitströme I_{Abl,1}, I_{Abl,2} liegen können. Um nun einen potentiell auftretenden resistiven Fehlerstrom I_{Fehl} mit derart geringen Stromstärken zuverlässig und mit geringem Aufwand messen zu können, wird vorgeschlagen, auf eine jeweils separate Messung eines Summenstroms I_{Sum,1} I_{Sum,2} mit einem jeweils möglicherweise hohen, für beide PV-Strings 2.1, 2.2 jedoch ähnlichen Ableitstrom I_{Abl,1}, I_{Abl,2} zu verzichten. Stattdessen gibt der Stromwandler 31 als Messsignal den Unterschied, also die Differenz der Summenströme I_{Sum,1} I_{Sum,2} und damit auch der Ableitströme I_{Abl,1}, I_{Abl,2} zwischen den beiden PV-Strings 2.1, 2.2 aus. Dieser Unterschied ist, gemäß der oben genannten Voraussetzung der Ähnlichkeit der PV-Strings 2.1, 2.2, gering. Damit ist auch ein üblicherweise dauerhaft vorhandenes Messsignal, d. h. das Messsignal, das im Normalbetrieb der PV-Anlage 1 ohne Fehlerfall, also ohne Fehlerstrom I_{Fehl}, vorliegt, aufgrund der eintretenden Kompensation der Summenströme I_{Sum,1}, I_{Sum,2} ebenfalls gering.

Eine Änderung des Summenstroms I_{Sum,1}, I_{Sum,2} in einem der PV-Strings 2.1, 2.2, zum Beispiel, wenn eine Person einen spannungsführenden Leiter berührt, wirkt sich nur auf denjenigen der PV-Strings 2.1, 2.2 aus, an dem der Fehler aufgetreten ist, der also dem Fehler zugeordnet ist. Im Fehlerfall erhöht sich daher der verbleibende Unterschied zwischen den Summenströmen I_{Sum,1}, I_{Sum,2} der ähnlichen PV-Strings 2.1, 2.2 signifikant relativ zu dem ansonsten kompensierten und üblicherweise dauerhaft vorhandenem Messsignal. Dieser Effekt ist in dem Messsignal des Stromwandlers 31 gut erkennbar. Demzufolge kann ein entsprechend empfindlicher, günstiger Stromwandler 31 gewählt werden und der Fehlerstrom I_{Fehl} kann mit zuverlässigen und günstigen Mitteln detektiert werden.

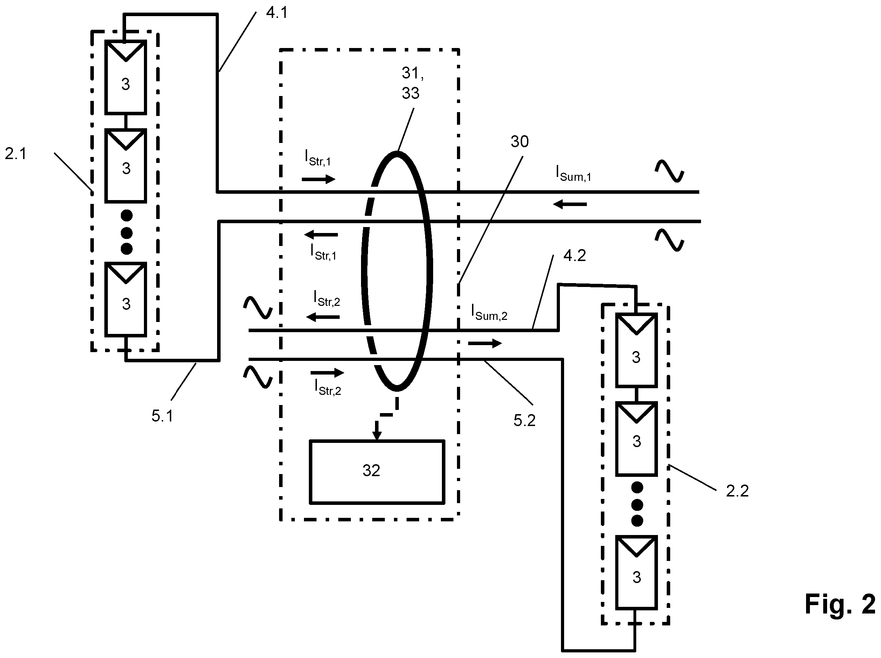

In **Fig. 2** ist eine erste Ausführungsform einer erfindungsgemäßen Detektionsvorrichtung 30 dargestellt, wie sie beispielsweise in einem erfindungsgemäßen PV-Wechselrichter 10 der PV-Anlage 1 aus **Fig. 1** angeordnet sein kann. Die Detektionsvorrichtung 30 beinhaltet einen Stromwandler 31, und eine mit dem Stromwandler 31 verbundene Auswerteeinheit 32. Dabei ist der Stromwandler 31 in **Fig. 2** als Durchsteckwandler 33 ausgebildet, der von den zwei PV-Strings 2.1, 2.2 der PV-Anlage 1 durchsetzt wird. Die Durchsetzung ist derart ausgebildet, dass sich ein in der positiven DC-Leitung 4.1 fließender DC-Strom I_{Str,1} des ersten PV-Strings 2.1 mit einem in der negativen DC-Leitung 5.1 in entgegengesetzter Richtung durch den Durchsteckwandler 33 fließenden und üblicherweise gleichgroßen DC-Strom I_{Str,1} kompensiert. Gleiches gilt so für die DC-Ströme I_{Str,2}, des zweiten PV-Strings 2.2, die in dessen positiver DC-Leitung 4.2 und in dessen negativer DC-Leitung 5.2 fließen. Die DC-Ströme I_{Str,1}, I_{Str,2} sind somit üblicherweise Gegentakt-Signale, die innerhalb der DC-Leitungen fließen. Diese als Gegentakt-Signale auftretenden DC-Ströme I_{Str,1}, I_{Str,2} fließen insbesondere nicht, zumindest nicht in einem Normalbetrieb der PV-Anlage 1, bei dem kein Fehlstrom I_{Fehl} vorliegt, von den DC-Leitungen gegen Erdpotential.

Zusätzlich zu dem DC-Potential auf den positiven DC-Leitungen 4.1, 4.2 und auf den negativen DC-Leitungen 5.1, 5.2 der beiden PV-Strings 2.1, 2.2 ist jeweils gegenüber dem Erdpotential ein AC-Potential überlagert. Das AC-Signal ist topologiebedingt vorhanden, weil der PV-Wechselrichter 10, an den die PV-Strings 2.1, 2.2 eingangsseitig angeschlossen sind, ausgangsseitig mit dem AC-Netz verbunden ist. Bei dem AC-Signal, welches in **Fig. 2** mittels der Wellenlinien illustriert ist, handelt es sich üblicherweise um ein Gleichtakt-Signal gegenüber dem Erdpotential. Hieraus ergibt sich in Verbindung mit den parasitären Kapazitäten 6.1, 6.2 der beiden PV-Strings 2.1, 2.2 jeweils ein Ableitstrom I_{Abl,1} I_{Abl,2}, und damit jeweils ein Summenstrom I_{Sum,1} I_{Sum,2}, der von jedem der PV-Strings 2.1, 2.2 gegen das Erdpotential PE fließt. Die Durchsetzung des Durchsteckwandlers 33 hinsichtlich der Summenströme I_{Sum,1} I_{Sum,2}, ist nun derart, dass der erste Summenstrom I_{Sum,1} des ersten PV-Strings 2.1 den Durchsteckwandler in entgegengesetzter Richtung zu dem zweiten Summenstrom I_{Sum,2} des zweiten PV-Strings 2.2 durchsetzt. Da die parasitären Kapazitäten 6.1, 6.2 der PV-Strings 2.1, 2.2 ähnlich sind, ergibt sich im normalen Betrieb der PV-Strings 2.1, 2.2 (d.h. in Abwesenheit eines Fehlerstroms) eine weitestgehende Kompensation des Messsignals des Durchsteckwandlers 33 Tritt nun ein Fehlerstrom in einem der beiden PV-Strings 2.1, 2.2 auf, so addiert sich zu dem Ableitstrom des fehlerbehafteten PV-Strings und es resultiert ein signifikantes Messsignal des Stromwandlers 33.

Das beschriebene Prinzip ist auch auf PV-Wechselrichter 10 mit mehr als zwei PV-Strings anwendbar, indem immer die DC-Leitungen von jeweils zwei ähnlichen PV-Strings paarweise in der in **Fig. 2** dargestellten Weise durch einen Stromwandler 31, insbesondere einen Durchsteckwandler 33 geführt werden. Bei einer Anzahl n von PV-Strings werden somit eine Anzahl n/2 von Stromwandlern 31, insbesondere Durchsteckwandlern 31 benötigt. Alternativ dazu können jedoch auch die DC-Leitungen 4.1, 4.2, 5.1, 5.2 einer jeden anderen, geradzahligen Zahl von ähnlichen PV-Strings 2.1, 2.2 auf diese Art zusammengefasst werden, nämlich indem der Summenstrom der einen Hälfte der PV-Strings in der einen Richtung und der Summenstrom der anderen Hälfte der PV-Strings in der entgegengesetzten Richtung durch den genau einen gemeinsamen Durchsteckwandler 33 als Stromwandler 31 geführt wird.

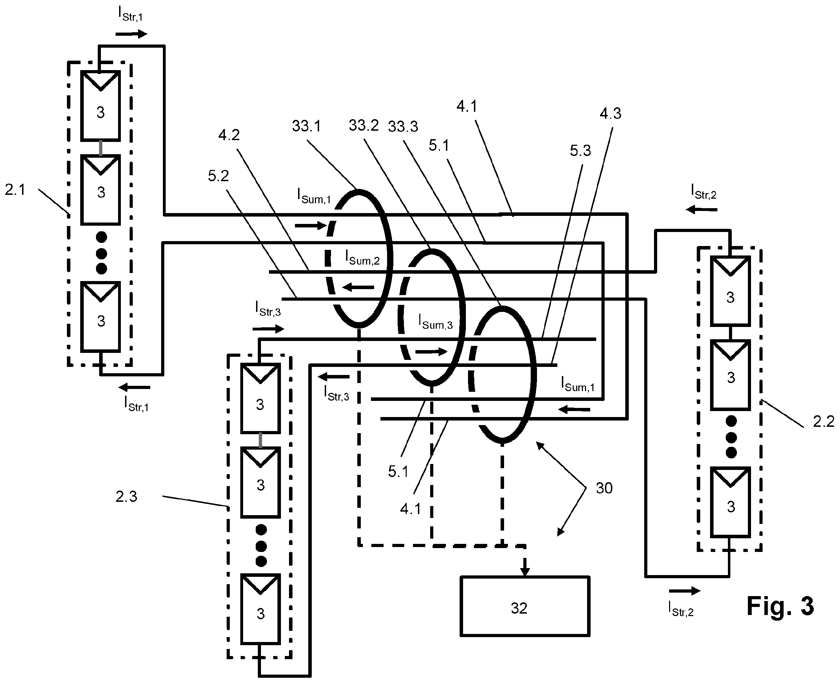

Bei Anwendungen, in denen eine geradzahlige Anzahl an PV-Strings 2.1, 2.2 mit einem gemeinsamen Stromwandler 31, wie in **Fig. 1** und **Fig. 2** dargestellt, überwacht werden, ist eine Lokalisierung einer sprunghaften Änderung eines Summenstroms I_{Sum,1}, I_{Sum,2} auf einen der PV-Strings 2.1, 2.2 nur indirekt möglich. Es kann zwar eine sprunghafte Änderung in der Gesamtheit der beiden PV-Strings 2.1, 2.2 erkannt werden, jedoch kann durch den Aufbau noch nicht erkannt werden, von welchem der beiden PV-Strings 2.1, 2.2 der sprunghafte Anstieg und damit der Fehlerstrom I_{Fehl} hervorgerufen wird. Eine Möglichkeit zur Bestimmung des jeweilig fehlerbehafteten der PV-Strings 2.1, 2.2 wird in Verbindung mit **Fig. 3** näher erläutert. **Fig. 3** zeigt eine zweite Ausführungsform einer erfindungsgemäßen Detektionsvorrichtung 30. Die zweite Ausführungsform ist in einigen Punkten ähnlich zu der ersten Ausführungsform der Detektionsvorrichtung 30 gemäß **Fig. 2** ausgeführt, weswegen hinsichtlich der Gemeinsamkeiten auf die Figurenbeschreibung der **Fig. 2** verwiesen wird. Im Folgenden werden hauptsächlich die Unterschiede der zweiten von der ersten Ausführungsform dargestellt.

Im Gegensatz zu der ersten Ausführungsform ist die zweite Ausführungsform der Detektionsvorrichtung 30 für insgesamt drei PV-Strings 2.1, 2.2, 2.3 ausgelegt und beinhaltet drei Durchsteckwandler 33.1, 33.2, 33.3, die mit der Auswerteeinheit 32 verbunden sind. Der erste DC-Strom I_{Str,1} des ersten PV-Strings 2.1 durchfließt den ersten Durchsteckwandler 33.1 zweimal, jeweils einmal in entgegengesetzter Richtung. Zusätzlich durchfließt der erste DC-Strom I_{Str,1} des ersten PV-Strings 2.1 den dritten Durchsteckwandler 33.3 ebenfalls zweimal, jeweils einmal in entgegengesetzter Richtung. Der zweite DC-Strom I_{Str,2} des zweiten PV-Strings 2.2 durchfließt den zweiten Durchsteckwandler 33.2 zweimal, jeweils einmal in entgegengesetzter Richtung. Zusätzlich durchfließt der zweite DC-Strom I_{Str,2} des zweiten PV-Strings 2.2 den ersten Durchsteckwandler 33.1 ebenfalls zweimal, jeweils einmal in entgegengesetzter Richtung. Der dritte DC-Strom I_{Str,3} des dritten PV-Strings 2.3 durchfließt den zweiten Durchsteckwandler 33.2 zweimal, jeweils einmal in entgegengesetzter Richtung. Zusätzlich durchfließt der dritte DC-Strom I_{Str,3} des dritten PV-Strings 2.3 den dritten Durchsteckwandler 33.3 zweimal, jeweils einmal in entgegengesetzter Richtung. Jeder Durchsteckwandler wird also stets von den DC-Strömen von jeweils einem Paar aus zwei der PV-Strings 2.1 - 2.3 durchflossen. Dabei ist die Durchsetzung derart ausgebildet, dass die Ableitströme I_{Abl,1}, I_{Abl,2} I_{Abl,3}, sowie auch die Summenströme I_{Sum,1}, I_{Sum,2} I_{Sum,3} für jedes Paar an PV-Strings 2.1 - 2.3 mit einem gemeinsamen Durchsteckwandler 33.1 - 33.3, den gemeinsamen Durchsteckwandler 33.1 - 33.3 in entgegengesetzter Richtung durchsetzen. Auf diese Weise ergibt sich auch hier für jeden der Durchsteckwandler eine jeweils paarweise wirkende Kompensation der Summenströme I_{Sum,1}, I_{Sum,2} I_{Sum,3}.

Mit einer in **Fig. 3** dargestellten Ausführungsform ist ein Lokalisieren desjenigen PV-Strings 2.1, 2.2, 2.3, der eine sprunghafte Änderung des Summenstroms tatsächlich ausgelöst hat, möglich. Dabei werden die Durchsteckwandler 33.1, 33.2, 33.3 derart verwendet, dass durch sie die DC-Leitungen 4.1, 4.2, 4.3, 5.1, 5.2, 5.3 von jeweils zwei PV-Strings 2.1, 2.2, 2.3 in Art einer "Daisy Chain" Kette kompensierend geführt werden.

Jeder der PV-Strings 2.1, 2.2, 2.3 in **Fig. 3** ist jeweils mit zwei bestimmten für ihn charakteristischen der drei Durchsteckwandler 33.1, 33.2, 33.3 verbunden. Ein sprunghafter Anstieg des Summenstroms I_{Sum,1}, I_{Sum,2} I_{Sum,3} an einem der PV-Strings 2.1, 2.2, 2.3 erzeugt daher einen Sprung des entsprechenden Messsignals in den zwei jeweils für ihn charakteristischen Durchsteckwandlern 33.1 - 33.3. Über einen Vergleich, welche zwei der insgesamt drei Durchsteckwandler 33.1 - 33.3 nun einen sprunghaften Anstieg des Messsignals aufweisen, kann auf den PV-String geschlossen werden, der den Fehler verursacht hat. Dabei kann der Vergleich der Messignale der einzelnen Durchsteckwandler und die Bestimmung des fehlerbehafteten PV-Strings 2.1 - 2.3 über die Auswerteeinheit 32 erfolgen.

Das hier beschriebene Vorgehen lässt sich auch auf eine Konfiguration der Detektionsvorrichtung 30 mit mehr als drei PV-Strings 2.1, 2.2, 2.3 übertragen. Allgemein ergibt sich, dass für eine Anzahl n von PV-Strings 2.1 - 2.n auch eine Anzahl n von Durchsteckwandlern benötigt werden, um nicht nur einen Fehler in einem der PV-Strings 2.1 - 2.n aufzuzeigen, sondern auch den jeweils fehlerbehafteten der PV-Strings 2.1 - 2.n zu bestimmen.

Eine Ungleichheit der paarweise betrachteten und jeweils einen Durchsteckwandler durchsetzenden PV-Strings 2.1, 2.2, 2.3 kann eine Übersteuerung des jeweiligen Durchsteckwandlers 33.1, 33.2, 33.3 bewirken. Umgekehrt kann von einer zu großen Ungleichheit der über einen Durchsteckwandler 33.1, 33.2, 33.3 am PV-Wechselrichter 10 angeschlossenen PV-Strings 2.1, 2.2, 2.3 ausgegangen werden, wenn das Messsignal eines gemeinsam genutzten Durchsteckwandlers 33.1, 33.2, 33.3 auch im Normalbetrieb der PV-Anlage 1 dauerhaft eine Differenz der Summenströme I_{Sum,1}, I_{Sum,2} I_{Sum,3} mit hoher Stromstärke erfasst, wenn also diese Stromstärke einen bestimmten Bemessungs-Wert als zweiten Schwellwert S_{TH,2} dauerhaft übersteigt. In einem solchen Fall können jedoch entsprechende Maßnahmen eingeleitet werden, z. B. eine andere Gruppierung in Bezug auf die gemeinsam genutzten Durchsteckwandler 33.1 - 33.3 und/oder gegebenenfalls eine Änderung einzelner PV-Strings 2.1 - 2.3 in Bezug auf Typ und Anzahl der dem PV-String 2.1 - 2.3 zugeordneten PV-Module 3.

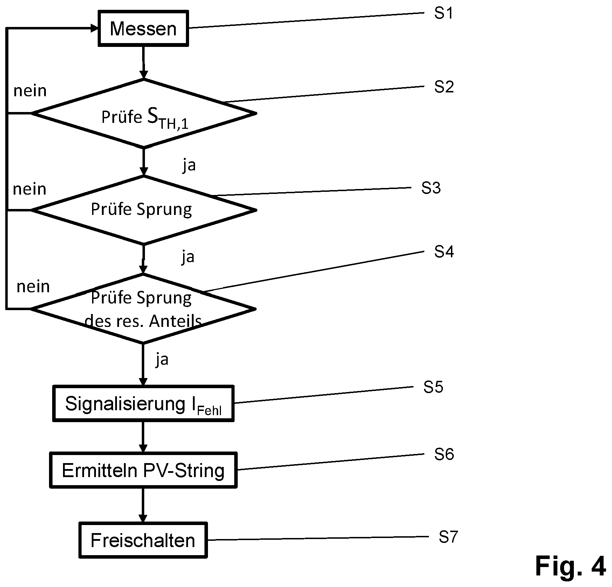

In **Fig. 4** ist ein Ablaufdiagramm eines erfindungsgemäßen Verfahrens zur Detektion eines Fehlerstroms gemäß einer Ausführungsform dargestellt.

In Schritt S1 wird ein Messsignal des zumindest einen Stromwandlers 31 detektiert. Das Messsignal repräsentiert dabei z. B. eine Differenz eines von dem ersten PV-String 2.1 gegen das Erdpotential PE fließenden ersten Summenstroms I_{Sum,1} und eines von dem zweiten PV-String 2.2 gegen das Erdpotential PE fließenden zweiten Summenstroms I_{Sum,2}. Bei Verwendung einer Detektionsvorrichtung 30, die gemäß **Fig. 3** für mehr als zwei PV-Strings 2.1, 2.2 ausgelegt ist, kann das Messsignal zusätzlich auch eine Differenz eines von dem ersten PV-String 2.1 gegen das Erdpotential PE fließenden ersten Summenstroms I_{Sum,1} und eines von dem dritten PV-Strings 2.3 gegen das Erdpotential PE fließenden dritten Summenstroms I_{Sum,3} und/oder eine Differenz eines von dem zweiten PV-String 2.2 gegen das Erdpotential PE fließenden zweiten Summenstrom I_{Sum,2} und eines von dem dritten PV-String 2.3 gegen das Erdpotential PE fließenden dritten Summenstroms I_{Sum,3} beinhalten.

In Schritt S2 wird überprüft, ob das detektierte Messsignal einen ersten Schwellwert S_{TH,1} übersteigt. Falls nein, wird mit Schritt S1 fortgefahren. Falls ja, folgt der optionale Schritt S3, bei dem überprüft wird, ob sich das Messsignal sprunghaft ändert. Ist dies der Fall, so wird im optionalen Schritt S4 geprüft, ob sich der resistive Anteil des Messsignals sprunghaft ändert. Ist dies der Fall, so wird mit Schritt S5 fortgefahren. Falls die Prüfung der optionalen Schritte S3 oder S4 negativ ist, wird mit Schritt S1 fortgefahren. Falls die optionalen Schritte S3 und S4 nicht durchgeführt werden, wird nach erfolgter Prüfung in Schritt S2 dann, wenn das detektierte Messsignal den ertsen Schwellwert STH,1 übersteigt, mit dem Schritt S5 fortgefahren.

In Schritt S5 wird ein Fehlerstrom I_{Fehl} signalisiert, wenn das detektierte Messsignal gemäß der Prüfung in Schritt S2 den ersten Schwellwert S_{TH,1} übersteigt. Eine Signalisierung kann beispielsweise ein innerhalb der Auswerteeinrichtung 32 generiertes Alarmsignal sein, das weitere Maßnahmen auslösen kann. Eine Signalisierung des Fehlerstroms I_{Fehl} kann initiiert durch die Auswerteeinheit 32 auch über ein per Funk übertragenes Signal an einen Betreiber der PV-Anlage 1 erfolgen.

An Schritt S5 schließt sich der optionale Schritt S6 an, der insbesondere für eine Ausführung der Detektionsvorrichtung 30 gemäß **Fig. 3** durchgeführt werden kann. In Schritt S6 wird der betroffene PV-String 2.1, 2.2, 2.3 ermittelt, der die Änderung des Messsignals und damit den Fehlerstrom I_{Fehl} ausgelöst hat. Nach Ermittlung des betroffenen PV-Strings 2.1, 2.2, 2.3 kann dieser in Schritt S7 freigeschaltet werden, um mögliche Gefahren für Personen 7 abzuwenden. Dabei kann die PV-Anlage 1 zusammen mit den restlichen nicht vom Fehlerstrom I_{Fehl} betroffenen PV-Strings weiterbetrieben werden.

### Bezugszeichenliste

- 1: Photovoltaik (PV) - Anlage
- 2.1, 2.2, 2.3: PV-String
- 3: PV-Modul
- 4.1, 4.2, 4.3: DC-Leitung
- 5.1, 5.2, 5.3: DC-Leitung
- 6.1, 6.2: parasitäre Kapazität
- 7: Person
- 8: PV-Generator
- 10: Wechselrichter
- 11.1, 11.2: DC-Eingang
- 12: AC-Ausgang
- 13: DC/DC-Wandler
- 14: DC-Zwischenkreis
- 15: DC/AC-Wandler
- 16: Steuerungseinheit
- 20: Wechselspannungsnetz (AC-Netz)
- 30: Detektionsvorrichtung
- 31: Stromwandler
- 32: Auswerteeinheit
- 33, 33.1, 33.2, 33.3: Durchsteckwandler
- S1, S2, S3, S4, S5, S6, S7: Verfahrensschritte
- I_{Sum,1}, I_{Sum,2}, I_{Sum,3}: Summenstrom
- I_{Fehl}: Fehlerstrom
- I_{Abl,1}, I_{Abl,2}: Ableitstrom
- I_{Str,1}, I_{Str,2}, I_{Str,3}: DC-Strom
- PE: Erdpotential
- S_{TH,1}: erster Schwellwert
- S_{TH,2}: zweiter Schwellwert

## Patentansprüche

1. Anordnung zur Detektion eines Fehlerstroms (I_{Fehl}) an einem PV-Generator (8) und/oder an dem PV-Generator (8) zugeordneten DC-Leitungen (4.1 - 4.3, 5.1 - 5.3) einer PV-Anlage (1), wobei der PV-Generator (8) zumindest einen ersten PV-String (2.1) und einen zweiten PV-String (2.2) aufweist, die über jeweils zwei DC-Leitungen (4.1, 5.1, 4.2, 5.2), die von der Anordnung umfasst sind, mit einem PV-Wechselrichter (10) der PV-Anlage (1) verbunden sind, wobei die Anordnung weiterhin eine Detektionsvorrichtung (30) umfasst, die zumindest einen Stromwandler (31) und eine mit dem zumindest einen Stromwandler (31) verbundene Auswerteeinheit (32) aufweist, wobei
- der Stromwandler (31) als ein von dem ersten PV-String (2.1) und dem zweiten PV-String (2.2) gemeinsam nutzbarer Durchsteckwandler (33) ausgebildet ist, der zur Detektion des Messsignals von den zwei DC-Leitungen (4.1, 5.1) des ersten PV-Strings (2.1) und den zwei DC-Leitungen (4.2, 5.2) des zweiten PV-Strings (2.2) durchsetzt wird,
- wobei die zwei DC-Leitungen (4.1, 5.1) des ersten PV-Strings (2.1) so zueinander angeordnet sind, dass während eines Normalbetriebs der PV-Anlage (1) ein darin fließender DC-Strom (I_{Str,1}) den Durchsteckwandler (33) in zwei zueinander entgegengesetzten Richtungen durchsetzt, und wobei die zwei DC-Leitungen (4.2, 5.2) des zweiten PV-Strings (2.2) so zueinander angeordnet sind, dass während des Normalbetriebs der PV-Anlage (1) ein darin fließender DC-Strom (I_{Str,2}) den Durchsteckwandler (33) in zwei zueinander entgegengesetzten Richtungen durchsetzt, **dadurch gekennzeichnet, dass**
eine mit einem positiven Pol des ersten PV-Strings (2.1) verbundene DC-Leitung (4.1) relativ zu einer mit einem positiven Pol des zweiten PV-Strings (2.2) verbundene DC-Leitung (4.2) so angeordnet ist, dass während des Normalbetriebs der PV-Anlage (1) die DC-Ströme (I_{Str,1}, I_{Str,2}) in den den positiven Polen zugeordneten DC-Leitungen (4.1, 4.2) den Durchsteckwandler (33) in entgegengesetzten Richtungen durchsetzen,
- so dass ein Messsignal des gemeinsam nutzbaren Stromwandlers (31) eine Differenz eines von dem ersten PV-String (2.1) gegen das Erdpotential (PE) fließenden ersten Summenstroms (I_{Sum,1}) und eines von dem zweiten PV-String (2.2) gegen das Erdpotential (PE) fließenden zweiten Summenstroms (I_{Sum,2}) repräsentiert.

2. Anordnung nach Anspruch 1, **dadurch gekennzeichnet, dass** der erste PV-String (2.1) eine Kombination aus zwei PV-Teilstrings umfasst, deren DC-Leitungen so zueinander angeordnet sind, dass während eines Normalbetriebs der PV-Anlage (1) die DC-Ströme in den den positiven Polen der PV-Teilstrings zugeordneten DC-Leitungen den Durchsteckwandler (33) in gleichen Richtungen durchsetzen, wobei optional der erste PV-Teilstring so ausgelegt ist, dass eine ihm zugeordnete Nominalleistung um zumindest 50% kleiner, bevorzugt um zumindest 70% kleiner ist als eine Nominalleistung des zweiten PV-Teilstrings.

3. Anordnung nach einem der vorangehenden Ansprüche, wobei der Stromwandler (31) auf einen Maximalwert ausgelegt ist, der einem Wert von maximal 50%, bevorzugt von maximal 25%, besonders bevorzugt von maximal 15% des größeren der beiden Werte aus einem ersten Ableitstrom (I_{Abl,1}) und einem zweiten Ableitstrom I_{Abl,2} entspricht, wobei der erste Ableitstrom (I_{Abl,1}) einen im Normalbetrieb der PV-Anlage (1) von dem ersten PV-String (2.1) gegen das Erdpotential (PE) fließenden Strom kennzeichnet und der zweite Ableitstrom (I_{Abl,2}) einen im Normalbetrieb der PV-Anlage (1) von dem zweiten PV-String (2.2) gegen das Erdpotential (PE) fließenden Strom kennzeichnet.

4. Anordnung nach einem der Ansprüche 1 bis 2, wobei die PV-Anlage (1) eine Anzahl PV-Strings (2.1-2.3) aufweist, wobei die Anzahl größer zwei ist, wobei die Detektionsvorrichtung (30) eine gleichgroße Anzahl an Durchsteckwandlern (33) aufweist, die mit der Auswerteinheit (32) der Detektionsvorrichtung (30) verbunden sind, wobei zur Detektion des Messsignals jeder der Durchsteckwandler (33) von den DC-Leitungen (4.1 - 4.3, 5.1 - 5.3) zweier verschiedener PV-Strings (2.1 - 2.3) durchsetzt wird, und wobei die DC-Leitungen (4.1-4.3, 5.1-5.3) jedes PV-Strings (2.1-2.3) jeweils zwei verschiedene der Durchsteckwandler (33) durchsetzen.

5. Verfahren zur Detektion eines Fehlerstroms (I_{Fehl}) an einer PV-Anlage (1), wobei ein PV-Generator (8) der PV-Anlage (1) zumindest einen ersten PV-String (2.1) und einen zweiten PV-String (2.2) aufweist, die über jeweils zwei DC-Leitungen (4.1, 5.1, 4.2, 5.2) mit einem PV-Wechselrichter (10) der PV-Anlage (1) verbunden sind, mit einer die jeweils zwei DC-Leitungen (4.1, 5.1, 4.2, 5.2) umfassenden Anordnung nach einem der vorangehenden Ansprüche **umfassend die Schritte:**
Detektion eines Messsignals des zumindest einen als Durchsteckwandler (33) ausgebildeten Stromwandlers (31), wobei das Messsignal eine Differenz eines von dem ersten PV-String (2.1) gegen das Erdpotential (PE) fließenden ersten Summenstroms (I_{Sum,1}) und eines von dem zweiten PV-String (2.2) gegen das Erdpotential (PE) fließenden zweiten Summenstroms (I_{Sum,2}) repräsentiert;
Signalisierung eines Fehlerstroms (I_{Fehl}), wenn das detektierte Messsignal einen ersten Schwellwert (S_{TH,1}) übersteigt.

6. Verfahren nach Anspruch 5, wobei die Signalisierung des Fehlerstrom (I_{Fehl}) nur dann erfolgt, wenn das Messsignal den ersten Schwellwert (S_{TH,1}) mit einem sprungartigen Anstieg überschreitet, der eine Änderung der Differenz des ersten Summenstroms (I_{Sum,1}) und des zweiten Summenstroms (I_{Sum,2}) von zumindest 10mA, vorteilhafterweise von zumindest 20mA repräsentiert.

7. Verfahren nach einem der Ansprüche 5 oder 6, wobei ein resistiver Stromanteil des von dem zumindest einen Stromwandler (31) detektierten Messsignals bestimmt wird, wobei optional der Fehlerstrom (I_{Fehl}) nur dann signalisiert wird, wenn das von dem Stromwandler (31) detektierte Messsignal bei Überschreitung des ersten Schwellwertes (S_{TH,1}) eine sprunghafte Änderung eines resistiven Stromanteils um zumindest 10mA, vorteilhafterweise um zumindest 20mA aufweist.

8. Verfahren nach einem der Ansprüche 5 bis 7, wobei der PV-Generator (8) der PV-Anlage (1) eine Anzahl an PV-Strings (2.1-2.3) aufweist, wobei die Anzahl größer zwei ist, und wobei die Detektionsvorrichtung (30) eine gleichgroße Anzahl an Stromwandlern (31) aufweist, wobei ein den Fehlerstrom verursachender PV-String (2.1-2.3) darüber ermittelt wird, dass zur Detektion des Messsignals jeweils zwei der PV-Strings (2.1-2.3) jeweils einen der Stromwandler (31) gemeinsam nutzen und wobei jeder der PV-Strings (2.1-2.3) jeweils zwei der Stromwandler (31) nutzt.

9. Verfahren nach einem der Ansprüche 5 bis 8, wobei in Reaktion auf die Signalisierung des Fehlerstroms (I_{Fehl}) der PV-Generator (8) oder lediglich der den Fehlerstrom (I_{Fehl}) verursachende PV-String (2.1-2.3) des PV-Generators (8) freigeschaltet wird.

10. Verfahren nach einem der Ansprüche 5 bis 9, wobei DC-Leitungen (4.1-4.3, 5.1-5.3) einer ersten Gruppe an PV-Strings (2.1-2.3) und einer gleich großen zweiten Gruppe an PV-Strings einen gemeinsamen Durchsteckwandler (31) so durchsetzen, dass jeder der PV-Strings (2.1-2.3) der ersten Gruppe einen gegen das Erdpotential (PE) fließenden ersten Summenstrom (I_{Sum,1}) aufweist, der von einem gegen das Erdpotential (PE) fließenden zweiten Summenstrom (I_{Sum,2}) eines korrespondierenden PV-Strings der zweiten Gruppe zumindest annähernd kompensiert wird.

11. Verfahren nach einem der Ansprüche 5 bis 10, wobei die zwei PV-Strings (2.1, 2.2) eines gemeinsam genutzten Stromwandlers (31) sich so ähneln, dass bei einem Normalbetrieb der PV-Anlage (1) eine Differenz eines von dem ersten PV-String (2.1) gegen das Erdpotential (PE) fließenden ersten Ableitstroms (I_{Abl,1}) und eines von dem zweiten PV-String (2.2) gegen das Erdpotential (PE) fließenden zweiten Ableitstroms (I_{Abl,2}) einen zweiten Schwellwert (S_{TH,2}) unterschreitet.

12. Verfahren nach Anspruch 11, wobei der zweite Schwellwert (S_{TH,2}) einem Wert von 25%, vorteilhafterweise einem Wert von 15% bezogen auf ein Maximum aus dem ersten Ableitstrom (I_{Abl,1}) und dem zweiten Ableitstrom (I_{Abl,2}) entspricht.

13. PV-Wechselrichter (10) mit einem AC-Ausgang (12) zum Anschluss an ein Wechselspannungsnetz (20) und zumindest zwei DC-Eingängen (11.1, 11.2) zum Anschluss von zumindest zwei PV-Strings (2.1, 2.2, 2.3) eines PV-Generators (8), **dadurch gekennzeichnet, dass** der PV-Wechselrichter (10) eine Anordnung nach einem der Ansprüche 1 bis 4 aufweist und über die jeweils zwei DC-Leitungen (4.1, 5.1, 4.2, 5.2) der Anordnung mit den zumindest zwei PV-Strings (2.1, 2.2, 2.3) verbunden ist, und/oder zur Durchführung eines Verfahrens nach einem der Ansprüche 5 bis 12 ausgelegt und eingerichtet ist.

14. PV-Wechselrichter (10) nach Anspruch 13, **dadurch gekennzeichnet, dass** der PV-Wechselrichter (10) eine nominelle Leistung von zumindest 10 kW aufweist.

15. PV-Wechselrichter (10) nach Anspruch 13 oder 14, **dadurch gekennzeichnet, dass** der PV-Wechselrichter (10) als ein transformatorloser PV-Wechselrichter ausgebildet ist.

## Claims

1. Arrangement for detecting a fault current (I_{fault}) at a PV generator (8) and/or at DC lines (4.1 - 4.3, 5.1 - 5.3) of a PV installation (1) assigned to the PV generator (8), wherein the PV generator (8) has at least a first PV string (2.1) and a second PV string (2.2), which are connected via in each case two DC lines (4.1, 5.1, 4.2, 5.2), that are comprised by the arrangement, to a PV inverter (10) of the PV installation (1), wherein the arrangement further comprises a detection device (30), that has at least one current transformer (31) and an evaluation unit (32) connected to the at least one current transformer (31), wherein
- the current transformer (31) is designed as a toroidal current transformer (33) jointly useable by the first PV string (2.1) and the second PV string (2.2) that is passed through by the two DC lines (4.1, 5.1) of the first PV string (2.1) and the two DC lines (4.2, 5.2) of the second PV string (2.2) for the detection of the measurement signal,
- wherein the two DC lines (4.1, 5.1) of the first PV string (2.1) are arranged relative to one another such that, during normal operation of the PV installation (1), a DC current (I_{Str,1}) flowing therein passes through the toroidal current transformer (33) in two opposite directions, and wherein the two DC lines (4.2, 5.2) of the second PV string (2.2) are arranged relative to one another such that, during normal operation of the PV installation (1), a DC current (I_{Str,2}) flowing therein passes through the toroidal current transformer (33) in two opposite directions, **characterized in that a** DC line (4.1) connected to a positive pole of the first PV string (2.1) is arranged relative to a DC line (4.2) connected to a positive pole of the second PV string (2.2) such that, during normal operation of the PV installation (1), the DC currents (I_{Str,1}, I_{Str,2}) in the DC lines (4.1, 4.2) assigned to the positive poles pass through the toroidal current transformer (33) in opposite directions,
- so that a measurement signal of the jointly usable current transformer (31) represents a difference between a first summation current (I_{sum,1}) flowing from the first PV string (2.1) toward the ground potential (PE) and a second summation current (I_{Sum,2}) flowing from the second PV string (2.2) toward the ground potential (PE).

2. Arrangement according to Claim 1, **characterized in that** the first PV string (2.1) comprises a combination of two PV substrings, the DC lines of which are arranged relative to one another such that, during normal operation of the PV installation (1), the DC currents in the DC lines assigned to the positive poles of the PV substrings pass through the toroidal current transformer (33) in the same directions, wherein the first PV substring is optionally designed such that a nominal power assigned thereto is at least 50% smaller, preferably at least 70% smaller than a nominal power of the second PV substring.

3. Arrangement according to one of the preceding claims, wherein the current transformer (31) is designed for a maximum value which corresponds to a value of at most 50%, preferably of at most 25%, particularly preferably of at most 15% of the greater of the two values from among a first leakage current (I_{leak,1}) and a second leakage current I_{leak,2}, wherein the first leakage current (I_{leak,1}) characterizes a current flowing from the first PV string (2.1) toward the ground potential (PE) in normal operation of the PV installation (1), and the second leakage current (I_{leak,2}) characterizes a current flowing from the second PV string (2.2) toward the ground potential (PE) in normal operation of the PV installation (1).

4. Arrangement according to one of Claims 1 to 2, wherein the PV installation (1) has a number of PV strings (2.1-2.3), wherein the number is greater than two, wherein the detection device (30) has an equal number of toroidal current transformers (33) connected to the evaluation unit (32) of the detection device (30), wherein for the detection of the measurement signal, each of the toroidal current transformers (33) is passed through by the DC lines (4.1 - 4.3, 5.1 - 5.3) of two different PV strings (2.1 - 2.3), and wherein the DC lines (4.1-4.3, 5.1-5.3) of each PV string (2.1-2.3) each pass through two different ones of the toroidal current transformers (33).

5. Method for detecting a fault current (I_{fault}) on a PV installation (1), wherein a PV generator (8) of the PV installation (1) has at least a first PV string (2.1) and a second PV string (2.2), which are connected via in each case two DC lines (4.1, 5.1, 4.2, 5.2) to a PV inverter (10) of the PV installation (1), with an arrangement comprising the two DC lines (4.1, 5.1, 4.2, 5.2) in each case according to one of the preceding claims, **comprising the steps of:**
detecting a measurement signal of the at least one current transformer (31) designed as a toroidal current transformer (33), wherein the measurement signal represents a difference between a first summation current (I_{Sum,1}) flowing from the first PV string (2.1) toward the ground potential (PE) and a second summation current (I_{Sum,2}) flowing from the second PV string (2.2) toward the ground potential (PE);
signaling a fault current (I_{fault}) if the detected measurement signal exceeds a first threshold value (S_{TH,1}).

6. Method according to Claim 5, wherein signaling of the fault current (I_{fault}) occurs only if the measurement signal exceeds the first threshold value (S_{TH,1}) with an abrupt increase, which represents a change in the difference between the first summation current (I_{Sum,1}) and the second summation current (I_{Sum,2}) of at least 10 mA, advantageously of at least 20 mA.

7. Method according to one of Claims 5 or 6, wherein a resistive current component of the measurement signal detected by the at least one current transformer (31) is determined, wherein the fault current (I_{fault}) is optionally signaled only if the measurement signal detected by the current transformer (31) has an abrupt change in a resistive current component by at least 10 mA, advantageously by at least 20 mA, when the first threshold value (S_{TH,1}) is exceeded.

8. Method according to one of Claims 5 to 7, wherein the PV generator (8) of the PV installation (1) has a number of PV strings (2.1-2.3), wherein the number is greater than two, and wherein the detection device (30) has an equal number of current transformers (31), wherein a PV string (2.1-2.3) causing the fault current is determined by two of the PV strings (2.1-2.3) in each case jointly using one of the current transformers (31) for the detection of the measurement signal, and wherein each of the PV strings (2.1-2.3) uses two of the current transformers (31) in each case.

9. Method according to one of Claims 5 to 8, wherein, in response to the signaling of the fault current (I_{fault}), the PV generator (8) or only the PV string (2.1-2.3) of the PV generator (8) causing the fault current (I_{fault}) is isolated.

10. Method according to one of Claims 5 to 9, wherein DC lines (4.1-4.3, 5.1-5.3) of a first group of PV strings (2.1-2.3) and an equally sized second group of PV strings pass through a shared toroidal current transformer (31) such that each of the PV strings (2.1-2.3) of the first group has a first summation current (I_{Sum,1}) that flows toward the ground potential (PE) and is at least approximately compensated by a second summation current (I_{sum,2}) of a corresponding PV string of the second group flowing toward the ground potential (PE).

11. Method according to one of Claims 5 to 10, wherein the two PV strings (2.1, 2.2) of a jointly used current transformer (31) are similar to one another such that, in normal operation of the PV installation (1), a difference between a first leakage current (I_{leak,1}) flowing from the first PV string (2.1) toward the ground potential (PE) and a second leakage current (I_{leak,2}) flowing from the second PV string (2.2) toward the ground potential (PE) falls below a second threshold value (S_{TH,2}).

12. Method according to Claim 11, wherein the second threshold value (S_{TH,2}) corresponds to a value of 25%, advantageously a value of 15%, based on a maximum from among the first leakage current (I_{leak,1}) and the second leakage current (I_{leak,2}).

13. PV inverter (10) comprising an AC output (12) for connection to an AC voltage network (20) and at least two DC inputs (11.1, 11.2) for connecting at least two PV strings (2.1, 2.2, 2.3) of a PV generator (8), **characterized in that** the PV inverter (10) has an arrangement according to one of claims 1 to 4 and is connected to the at least two PV strings (2.1, 2.2, 2.3) via the two DC lines (4.1, 5.1, 4.2, 5.2) of the arrangement and/or is designed and configured to carry out a method according to one of Claims 5 to 12.

14. PV inverter (10) according to Claim 13, **characterized in that** the PV inverter (10) has a nominal power of at least 10 kW.

15. PV inverter (10) according to Claim 13 or 14, **characterized in that** the PV inverter (10) is designed as a transformerless PV inverter.

## Revendications

1. Dispositif pour détecter un courant de défaut (I_{Fehl}) sur un générateur photovoltaïque (8) et/ou sur les câbles CC (4.1 - 4.3, 5.1 - 5.3) d'une installation photovoltaïque (1), le générateur photovoltaïque (8) comportant au moins une première chaîne photovoltaïque (2.1) et une deuxième chaîne photovoltaïque (2.2) qui sont reliées, par l'intermédiaire de deux lignes à courant continu (4.1, 5.1, 4.2, 5.2) qui sont comprises dans l'agencement, à un onduleur photovoltaïque (10) de l'installation photovoltaïque (1), l'agencement comprenant en outre un dispositif de détection (30) qui comprend au moins un transformateur de courant (31) et une unité d'évaluation (32) reliée au au moins un transformateur de courant (31),
- le transformateur de courant (31) est conçu comme un transformateur de courant traversant (33) pouvant être utilisé conjointement par la première chaîne photovoltaïque (2.1) et la deuxième chaîne photovoltaïque (2.2), qui est traversé par les deux lignes à courant continu (4.1, 5.1) de la première chaîne photovoltaïque (2.1) et les deux lignes CC (4.2, 5.2) de la deuxième chaîne PV (2.2),
- les deux lignes CC (4.1, 5.1) de la première chaîne PV (2.1) étant disposées l'une par rapport à l'autre de telle sorte que, pendant le fonctionnement normal de l'installation PV (1), un courant CC (I_{Str,1}) qui y circule traverse le transformateur de courant traversant (33) dans deux directions opposées l'une à l'autre, et les deux lignes CC (4.2, 5.2) de la deuxième chaîne PV (2.2) étant disposées l'une par rapport à l'autre de telle sorte que, pendant le fonctionnement normal de l'installation PV (1), un courant CC (I_{Str,2}) qui y circule traverse le transformateur de courant traversant (33) dans deux directions opposées l'une à l'autre, **caractérisé en ce qu'**un câble CC (4.1) relié à un pôle positif de la première chaîne PV (2.1) est disposé par rapport à un câble CC (4.2) relié à un pôle positif de la deuxième chaîne PV (2.2) de telle sorte que, pendant le fonctionnement normal de l'installation photovoltaïque (1), les courants continus (I_{Str,1}, I_{Str,2}) dans les lignes à courant continu (4.1, 4.2) associées aux pôles positifs traversent le transformateur de courant traversant (33) dans des directions opposées,
- de sorte qu'un signal de mesure du transformateur de courant à usage commun (31) représente une différence entre un premier courant total (I_{Sum,1}) circulant depuis la première chaîne PV (2.1) par rapport au potentiel de terre (PE) et un deuxième courant total (ISum,2) par rapport au potentiel de terre (PE).

2. Dispositif selon la revendication 1, **caractérisé en ce que** la première chaîne PV (2.1) comprend une combinaison de deux sous-chaînes PV dont les câbles CC sont disposés les uns par rapport aux autres de telle sorte que, pendant le fonctionnement normal de l'installation PV (1), les courants CC dans les lignes CC associées aux pôles positifs des sous-chaînes PV traversent le transformateur traversant (33) dans les mêmes directions, la première sous-chaîne PV étant éventuellement conçue de telle sorte qu'une puissance nominale qui lui est associée soit inférieure d'au moins 50 %, de préférence d'au moins 70 %, à une puissance nominale de la deuxième sous-chaîne PV.

3. Dispositif selon l'une des revendications précédentes, le transformateur de courant (31) étant conçu pour une valeur maximale qui correspond à une valeur maximale de 50 %, de préférence de 25 %, de préférence au maximum 15 % de la plus grande des deux valeurs d'un premier courant de fuite (I_{Abl,1}) et d'un deuxième courant de fuite I_{Abl,2}, le premier courant de fuite (I_{Abl,1}) caractérisant un courant circulant par rapport au potentiel de terre (PE) et le deuxième courant de fuite (I_{Abl,2}) caractérise un courant circulant, en fonctionnement normal de l'installation photovoltaïque (1), depuis la deuxième chaîne photovoltaïque (2.2) par rapport au potentiel de terre (PE).

4. Dispositif selon l'une des revendications 1 à 2, dans lequel l'installation photovoltaïque (1) comporte un nombre de chaînes photovoltaïques (2.1-2.3) supérieur à deux, le dispositif de détection (30) comportant un nombre égal de convertisseurs à insertion (33) qui sont reliés à l'unité d'évaluation (32) du dispositif de détection (30), chacun des convertisseurs à insertion (33) étant traversé par les câbles CC (4.1 - 4.3, 5.1 à 5.3) de deux chaînes PV différentes (2.1 à 2.3), et les lignes CC (4.1 à 4.3, 5.1 à 5.3) de chaque chaîne PV (2.1 à 2.3) traversant respectivement deux des convertisseurs à passage (33) différents.

5. Procédé de détection d'un courant de défaut (I_{Fehl}) dans une installation photovoltaïque (1), un générateur photovoltaïque (8) de l'installation photovoltaïque (1) comportant au moins une première chaîne photovoltaïque (2.1) et une deuxième chaîne photovoltaïque (2.2) qui sont reliées à un onduleur photovoltaïque (10) de l'installation photovoltaïque (1) par l'intermédiaire de deux lignes CC (4.1, 5.1, 4.2, 5.2), avec un agencement comprenant les deux lignes à courant continu (4.1, 5.1, 4.2, 5.2) selon l'une des revendications précédentes, **comprenant les étapes** suivantes :
détection d'un signal de mesure d'au moins un transformateur de courant (31) conçu comme un transformateur de courant traversant (33), le signal de mesure représentant une différence entre un premier courant total (I_{Sum,1}) circulant depuis la première chaîne photovoltaïque (2.1) vers le potentiel de terre (PE) et un deuxième courant total (ISum,2) par rapport au potentiel de terre (PE) ;
signalisation d'un courant de défaut (I_{Fehl}) lorsque le signal de mesure détecté dépasse une première valeur seuil (S_{TH,1}).

6. Procédé selon la revendication 5, dans lequel la signalisation du courant de défaut (I_{Fehl}) n'a lieu que lorsque le signal de mesure dépasse la première valeur seuil (S_{TH,1}) avec une augmentation brusque qui représente une modification de la différence entre le premier courant total (I_{Sum,1}) et le deuxième courant total (I_{Sum,2}) d'au moins 10 mA, de préférence d'au moins 20 mA.

7. Procédé selon l'une des revendications 5 ou 6, dans lequel une composante de courant résistif du signal de mesure détecté par au moins un transformateur de courant (31) est déterminée, le courant de défaut (I_{Fehl}) n'étant signalé, en option, que lorsque le signal de mesure détecté par le transformateur de courant (31) présente, lors du dépassement de la première valeur seuil (S_{TH,1}), présente une variation brusque d'une composante de courant résistif d'au moins 10 mA, de préférence d'au moins 20 mA.

8. Procédé selon l'une des revendications 5 à 7, dans lequel le générateur photovoltaïque (8) de l'installation photovoltaïque (1) comporte un nombre de chaînes photovoltaïques (2.1-2.3) supérieur à deux, et dans lequel le dispositif de détection (30) comporte un nombre égal de transformateurs de courant (31), une chaîne photovoltaïque (2.1-2.3) à l'origine du courant de défaut étant déterminée par le fait que, pour la détection du signal de mesure, deux des chaînes photovoltaïques (2.1-2.3) utilisent chacune en commun l'un des transformateurs de courant (31) et que chacune des chaînes photovoltaïques (2.1-2.3) utilise deux des transformateurs de courant (31).

9. Procédé selon l'une des revendications 5 à 8, dans lequel, en réponse à la signalisation du courant de défaut (I_{Fehl}), le générateur photovoltaïque (8) ou uniquement la chaîne photovoltaïque (2.1-2.3) du générateur photovoltaïque (8) à l'origine du courant de défaut (I_{Fehl}) est déconnectée.

10. Procédé selon l'une des revendications 5 à 9, dans lequel les lignes CC (4.1-4.3, 5.1-5.3) d'un premier groupe de chaînes PV (2.1-2.3) et d'un deuxième groupe de chaînes PV de taille identique traversent un transformateur traversant commun (31) de telle sorte que chacune des chaînes PV (2.1-2.3)
du premier groupe présente un premier courant total (I_{Sum,1}) circulant vers le potentiel de terre (PE), qui est au moins approximativement compensé par un deuxième courant total (I_{Sum,2}) circulant vers le potentiel de terre (PE) d'une chaîne PV correspondante du deuxième groupe.

11. Procédé selon l'une des revendications 5 à 10, dans lequel les deux chaînes PV (2.1, 2.2) d'un transformateur de courant commun (31) sont si similaires que, lors d'un fonctionnement normal de l'installation PV (1), la différence entre un premier courant de fuite (IAbl,1) par rapport au potentiel de terre (PE) et d'un deuxième courant de fuite (I_{Abl,2}) circulant à partir de la deuxième chaîne photovoltaïque (2.2) par rapport au potentiel de terre (PE) est inférieure à une deuxième valeur seuil (S_{TH,2}).

12. Procédé selon la revendication 11, dans lequel la deuxième valeur seuil (S_{TH,2}) correspond à une valeur de 25 %, de préférence à une valeur de 15 %, par rapport à un maximum du premier courant de fuite (I_{Abl,1}) et du deuxième courant de fuite (I_{Abl,2}).

13. Onduleur photovoltaïque (10) avec une sortie CA (12) pour le raccordement à un réseau à tension alternative (20) et au moins deux entrées CC (11.1, 11.2) pour le raccordement d'au moins deux chaînes photovoltaïques (2.1, 2.2, 2.3) d'un générateur photovoltaïque (8), **caractérisé en ce que** l'onduleur photovoltaïque (10) présente un agencement selon l'une des revendications 1 à 4 et est relié, par l'intermédiaire des deux lignes CC (4.1, 5.1, 4.2, 5.2) de l'agencement avec les au moins deux chaînes photovoltaïques (2.1, 2.2, 2.3), et/ou est conçu et agencé pour mettre en œuvre un procédé selon l'une des revendications 5 à 12.

14. Onduleur photovoltaïque (10) selon la revendication 13, **caractérisé en ce que** l'onduleur photovoltaïque (10) présente une puissance nominale d'au moins 10 kW.

15. Onduleur photovoltaïque (10) selon la revendication 13 ou 14, **caractérisé en ce que** l'onduleur photovoltaïque (10) est conçu comme un onduleur photovoltaïque sans transformateur.
